(19) Europäisches Patentamt

European Patent Office

Office européen des brevets

(11) Publication number: **0 285 108 B1**

(12) **EUROPEAN PATENT SPECIFICATION**

(45) Date of publication of patent specification: 15.09.93

(51) Int. Cl.5: **H01L 39/14**, H01L 39/24

(21) Application number: **88105114.8**

(22) Date of filing: **29.03.88**

Divisional application 92116683.1 filed on 29/03/88.

(54) **Method of producing superconducting wire.**

(30) Priority: **31.03.87 JP 80028/87**
**09.10.87 JP 254969/87**

(43) Date of publication of application:
**05.10.88 Bulletin  88/40**

(45) Publication of the grant of the patent:
**15.09.93 Bulletin  93/37**

(84) Designated Contracting States:
**DE FR GB**

(56) References cited:
**EP-A- 0 171 918**
**US-A- 3 708 606**
**US-A- 4 411 959**
**US-A- 4 575 927**

**PHYSICAL REVIEW LETTERS, vol. 58, no. 9, 2nd March 1987, pages 908-910; M.K. WU et al.: "Superconductivity at 93 K in a new mixed-phase Y-Ba-Cu-O compound system at ambient pressure"**

(73) Proprietor: **SUMITOMO ELECTRIC INDUSTRIES LIMITED**
**No. 15, Kitahama 5-chome, Higashi-ku**
**Osaka-shi, Osaka 541(JP)**

(72) Inventor: **Yamauchi, Kazuhisa c/o Osaka Works**
**Sumitomo Electric Ind. Ltd. 1-3, Shimaya 1-chome**
**Konohana-ku Osaka(JP)**
Inventor: **Ohmatsu, Kazuya c/o Osaka Works**
**Sumitomo Electric Ind. Ltd. 1-3, Shimaya 1-chome**
**Konohana-ku Osaka(JP)**
Inventor: **Ishida, Tetsuya c/o Itami Works**
**Sumitomo Electric Ind. Ltd. 1-1, Koyakita 1-chome**
**Itami-chi Hyogo-ken(JP)**
Inventor: **Gotoh, Tomoji c/o Itami Works**
**Sumitomo Electric Ind. Ltd. 1-1, Koyakita 1-chome**
**Itami-chi Hyogo-ken(JP)**
Inventor: **Yazu, Syuji c/o Itami Works**
**Sumitomo Electric Ind. Ltd. 1-1, Koyakita 1-chome**
**Itami-chi Hyogo-ken(JP)**

ADVANCED CERAMIC MATERIALS- CERAMIC SUPERCONDUCTORS, vol. 2, no. 3B, July 1987, pages 388-400, Westerville, OH, US; R.W. McCALLUM et al.: "Problems in the production of YBa2Cu3Ox superconducting wire"

Phys. Rev. Lett., Vol. 58, no. 4, 26 January 1987. pp. 405-407, C.W.Chu et al

Inventor: **Jodai, Tetsuji c/o Itami Works Sumitomo Electric Ind. Ltd. 1-1, Koyakita 1-chome Itami-chi Hyogo-ken(JP)**

(74) Representative: **KUHNEN, WACKER & PARTNER Alois-Steinecker-Strasse 22 Postfach 1553 D-85315 Freising (DE)**

**Description**

DETAILED DESCRIPTION OF THE INVENTION

[Field of the Invention]

The present invention relates to a method of producing a superconducting member, in particular to a method of producing a superconducting wire and further a superconducting wire consisting of a usual conductor and a superconductor capable of effectively utilizing a superconducting material having a high superconducting critical temperature.

[Prior Art and Problems to be Solved]

A substance exhibits a complete diamagnetism under the superconducting phenomenon and a potential difference disappears even though a definite stationary current passes through an inside of the substance. So, various kinds of application of the superconductor as a transmission medium without showing any loss of electric power have been proposed.

That is to say, the fields of the superconductor include remarkably many fields such as an electric power field, such as MHD generation of electricity, transmission of electric power and storage of electric power, power field, such as magnetic levitation train and electro-magnetic propelling ship, and instrumental field, such as NMR, $\pi$-meson medical treatment and high-energy physics experimental apparatus as a super-sensitive sensor for a magnetic field, microwave, radio-active beam and the like.

In addition, the superconductor has been expected as an art capable of not only reducing a consumption of electric power but also realizing an element, which is remarkably speedy in action, also in the field of electronics represented by a Josephson's devices.

The superconductivity has been a phenomenon which is observed only at superlow temperatures. That is to say, a remarkably low temperature of 23.2 K has been said to be the limit of the superconducting critical temperature even for $Nb_3Ge$, which has been said to be the conventional superconducting material having the highest superconducting critical temperature Tc, for a long time.

Accordingly, the superconducting material has been cooled to Tc or less using liquid helium having a boiling point of 4.2 K to realize the superconducting phenomenon. However, the use of liquid helium has led to a remarkably increased technical burden and burden in cost due to a cooling facility including a liquefying device, and thus the realization of superconducting technique has been hindered.

It has, however, been recently reported that a sintered body comprising an oxide of elements of the group IIa or IIIa in the periodic table can be a superconductor having a remarkably high Tc, and thus the realization of the superconducting technique using a non-low temperature superconductor is going to be rapidly promoted. Composite oxides having a so-called pseudo-perovskite type crystalline structure such as $[La, Ba]_2CuO_4$ or $[La, Sr]_2CuO_4$, which seem to have an orthorhombic structure and the like similar to the crystalline structure of perovskite type oxides, have been already reported. Tc of 30 to 50 K remarkably high in comparison with that of the conventional superconducting materials has been observed for these substances. In addition, also Tc of 70 K or more has been reported for superconducting materials formed of oxides of Ba, Y and Cu.

However, since these superconducting materials are obtained in the form of sintered body at present, that is, they are produced by sintering molded products having an appointed length in a lump, a method of continuously producing a long object, such as a wire, has not been developed. In addition, the superconducting material obtained in the form of sintered body is remarkably fragile, so that the superconducting material is difficult to mold in many cases.

For manufacturing superconducting wires comprising a brittle superconducting material a so-called "powder-in-tube process" is known from the documents US-A-4 575 927, US-A-4 411 858, EP-A-0 171 918, and Advanced Ceram. Mat. - Ceram. Supercond. 2, 1987, US, July, No. 3B, pp. 388-399, R.W. Mc Callum et al. These documents do not disclose a way of providing a tube continuously.

In addition, a method, in which the superconducting wire is preliminarily produced and then coated with a usual conductor, has been used as a method of producing the composite wire consisting of the usual conductor and the superconductor.

However, according to such method, the process of producing the superconducting wire and the process of coating the superconducting wire with the usual conductor are required, so that such method is not efficient.

3

Thus, it is an object of the present invention to solve the above described points of problem of the conventional arts, whereby providing a novel method of continuously producing a superconducting material having a high Tc in the form of a wire highly stable in superconducting characteristic and superior in maintenance of shape.

It is another object of the present invention to provide a method of producing a composite wire comprising a superconductor in one step.

[Measures for Solving the Problems]

In order to achieve the first object of the present invention, the present invention at first provides a method of producing a superconducting wire comprising an oxide superconducting material having a high superconducting critical temperature, characterized by comprising the steps as set forth in claim 1.

And, according to the preferred embodiment of the present invention, said raw material powders preferably include mixture powders formed of oxides, nitrides, fluorides, carbonates, nitrates, oxalates or sulfates of one kind of element $\alpha$ selected from elements of the group IIa in the periodic table, one kind of element $\beta$ selected from elements of the group IIIa in the periodic table and one kind of element $\gamma$ selected from elements of the groups Ib, IIb, IIIb, IVa and VIIIa in the periodic table or powders of sintered composite oxides obtained by sintering said mixtures and then pulverizing them.

[Operation]

The method of producing a superconducting material according to the present invention is mainly characterized by that a series of steps are continuously carried out. In other words, according to the present invention, the process can be simplified and continuously carried out as a whole by the step of turning the plate material into the pipe and the supply of the raw material powders at the same time.

That is to say, as mentioned later, the metallic pipe having a small diameter preferably used as the material of the superconducting wire is produced generally in the form of electric welded tube. This step, as concretely mentioned later, is carried out by at first turning the plate material into the pipe having a U-shaped section by pressing and then the pipe having an O-shaped section followed by subjecting the butt portions to the seam welding. In these steps, the pipe does not form a closed section until after the seam welding. In particular, after the plate material is turned into the pipe having a U-shaped section, its portion corresponding to a side of the pipe is greatly opened. Accordingly, prior to the time when the pipe having a U-shaped section is turned into the pipe having an O-shaped section the former can be continuously supplied with the raw material powders from the side thereof.

Accordingly, according to the method of the present invention, the raw material powders are already housed in the pipe at the time when the plate material is formed as the pipe having a small diameter. Consequently, the material formed in a thin wire-like shape can be sintered to produce the superconducting wire by subjecting the pipe with the raw material powders housed therein to the heating treatment.

According to the method of the present invention, as concretely mentioned later, the steps can be continuously carried out, so that an appointed quantity of raw materials can be produced in the form of continuous product, whereby the long member, such as electric power transmission medium, can be advantageously produced.

In addition, it goes without saying that in these steps all of the conventional techniques accumulated in the production of electric welded tubes can be applied, that is, the plate material is turned into a pipe having a C-shaped section (by the use of a crimping press) before it is turned into the pipe having a U-shaped section or the butt surfaces formed when the pipe having a U-shaped section is formed are ground to expose the activated surface.

In addition, as mentioned later, some materials, of which the pipe is formed, bring about chemical reactions with composite oxide superconducting materials. In this case, it is preferable that the surface of the plate material is subjected to the surface treatment, for example the surface of the plate material is previously coated with stable substances.

The superconducting wire produced according to the present invention is a sintered wire with a sheath member having superior superconducting characteristics incidental to composite oxide sintered bodies. And, the sheath member functions as a support member, so that the superconducting wire produced according to the present invention has also a high mechanical strength. In addition, if the sheath member is formed of conductors, the sheath member functions as a current by-path and a radiating passage when quenched.

4

In view of these working methods and the desired characteristics, a plate material formed of one kind selected from the group consisting of stainless steel, Cu, Ag, Au, Pt, Pd, Rh, Fe, Pb, Sn, Cd, Ti, W, Mo, Zr, Hf, Ta and Nb or alloys thereof as the plate material, of which the pipe is formed, but it is not limited to them. In addition, Cu, Fe and the like are advantageous in easy workability and inexpensiveness, stainless steel and Pt being advantageous in chemical stability to have no chemical influence upon the superconducting material, and further Ag, Pd, Rh and the like being advantageous as the sheath member of the superconducting material, for which in particular the control of oxygen-concentration is required, since some of their oxides emit oxygen due to the change of temperature. The material of these sheath members should be suitably selected depending upon the use of the superconducting material and the like.

In addition, the method according to the present invention can be widely used as a method of producing long sintered products but in particular the use of composite oxide sintered bodies expressed by the general formula $\alpha_w\beta_x\gamma_y\delta_z$, wherein an element $\alpha$ is one kind selected from elements of the group IIa in the periodic table; an element $\beta$ being one kind selected from elements of the group IIIa in the periodic table; an element $\gamma$ being one kind selected from elements of the groups Ib, IIb, IIIb and VIIIa in the periodic table; $\delta$ being O; w, x, y and z being a number meeting $1 \leq w \leq 5$, $1 \leq x \leq 5$, $1 \leq y \leq 15$ and $1 \leq z \leq 20$, respectively, as the superconducting material leads to a more advantageous effect. In addition, said composite oxides include in particular composite oxides, such as Ba - Y - Cu, Ba - Ho - Cu, Sr - La - Cu or Ba - Dy - Cu, exhibiting particularly superior characteristics. These composite oxides seem to have a so-called pseudo-perovskite type crystalline structure including oxygen vacancies such as an orthorhombic structure. Such superconducting materials can be effectively used as the transmission medium of electric power and the like by turning them into a long superconductor according to the present invention.

It is desired in the sintering step of these composite oxide powders that the sintering temperature has an upper limit at a melting point of the sintered body and a difference between the sintering temperature and the melting point of the sintered body is 100°C or less. Because if the sintering temperature is lower than the above described range, the sintering reaction of the sintered body powders is not made progress and the strength of the resulting sintered body is extraordinarily reduced while if the sintering temperature exceeds the above described range, the liquid phase is produced during the sintering step to lead to the melting or decomposition of the sintered body, whereby remarkably lowering Tc of the sintered body.

In addition, according to the discovery by the present inventors, the addition of powdery oxides, carbonates, sulfates or nitrates of at least one kind of element selected from the group consisting of V, Nb, Ta, Mo, W, Ti, Cr, Mn, Ga, In, Cd, Sn, Tl, Pb and Zn to the element $\gamma$ at an atomic ratio of about 0.01 to 0.15 leads to more superior superconducting characteristics. In addition, it is preferable that the raw material powders have a particle diameter of 10 microns or less. The pulverization of the raw material powders realizes the effective sintering reaction, the uniform structure and an increase of an intercrystalline surface area playing an important function for the superconducting characteristics.

The present invention is below concretely described with reference to the preferred embodiments but the following preferred embodiments are merely illustrative. The technical scope of the present invention is not limited by them.

The drawings are below briefly described.

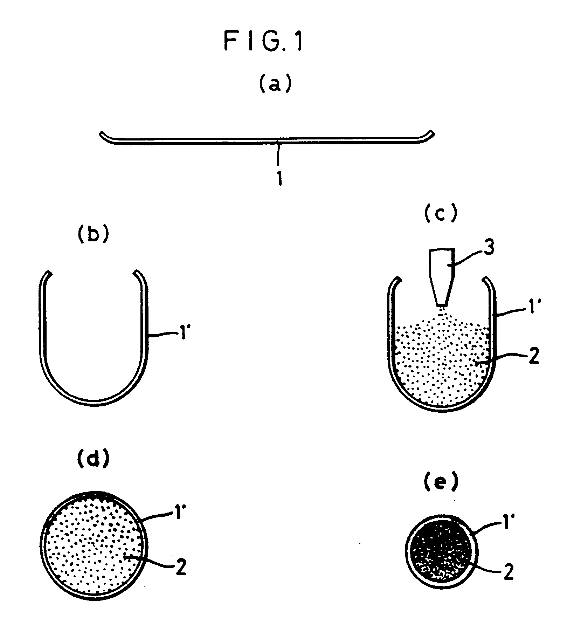

Fig. 1(a) to (e) is a progress chart showing every step in the method of producing the superconducting material according to EXAMPLE 1 of the present invention.

EXAMPLE 1

At first, the Cu plate 1 was turned into a pipe having a C-shaped section, as shown in Fig. 1(a), and then heated in air to oxidize the surface thereof. Then, side edge surfaces of the plate 1 were subjected to the grinding to expose the activated surfaces and adjust the shape of the end surfaces. Although merely the end surfaces in the direction of length of the plate 1 were ground in the present preferred embodiment, all side end surfaces may be ground and an endless pipe may be produced by connecting the plates with each other in turn.

Successively, this plate was turned into the pipe 1' having a U-shaped section by means of a forming roll, as shown in Fig. 1(b). Then, the inside of the pipe 1' having a U-shaped section was continuously supplied with the raw material powders 2 through the nozzle 3, as shown in Fig. 1(c).

The raw material powders 2 supplied here are powders of composite oxide sintered bodies obtained by preliminarily sintering the mixture comprising powders of $BaCO_3$, $Y_2O_3$ and CuO having the purity of 3N or more and an average particle diameter of 5 microns or less, so that the composition after sintering may become $Ba_2YCu_3O_7$, in air at 900°C for 24 hours and then roughly pulverizing the resulting caked powders followed by pulverizing until 4 microns in a ball mill made of high purity zirconia and repeating this process

5

further three times.

Next, the pipe 1' having a U-shaped section with the raw material powders 2 housed therein was turned into a pipe having an O-shaped section by means of the forming roll and the butt surfaces were welded by the TIG welding to obtain the Cu pipe 1' with the raw material powders housed therein, as shown in Fig. 1-(d).

Subsequently, the Cu pipe 1' with the raw material powders housed therein was reduced in diameter and drawn by means of a die disposed in a tandem relation to the forming roll line, as shown in Fig. 1(e).

The resulting wire was cut in 5 pieces having a length of 1 m and sample numbers ① to ⑤.

In addition, the above described wire was subjected to the intermediate annealing in an atmosphere of $N_2$ gas at 700°C for 1 hour and then reduced in diameter and drawn again by means of a reducing die to obtain a wire. Also this wire was cut in 5 pieces having a length of 1 m and sample numbers ⑥ to ⑩.

These samples ① to ⑩ were subjected to heat treatments under the conditions shown in the following Table 1 to obtain products.

Although the samples all were heated in an atmosphere of $N_2$ gas at 900°C, the heating time was changed. In addition, the samples ④ to ⑨ were heated and cooled and then heated at 700°C for 10 hours again followed by cooling at a rate of 10°C/min. In addition, the samples ⑤, ⑩ were heated also at 700°C for 10 hours and then cooled at a rate of 50°C/min.

Also the measured results of superconducting characteristics of each sample are shown in Table 1.

## Table 1

| Sample No. | Heating time (hr) | Tc (K) | Tci (K) |
|:---:|:---:|:---:|:---:|
| ① | 0.5 | 89 | 67 |
| ② | 6 | 87 | 72 |
| ③ | 12 | 89 | 84 |
| ④ | 12 | 91 | 82 |
| ⑤ | 12 | 90 | 83 |
| ⑥ | 0.5 | 86 | 73 |
| ⑦ | 6 | 88 | 79 |
| ⑧ | 12 | 95 | 91 |
| ⑨ | 12 | 94 | 89 |
| ⑩ | 12 | 97 | 93 |

The critical temperature Tc and the temperature Tci, at which the electric resistance becomes completely zero, were measured by the direct current four-probe method within a cryostat with fitting electrodes to both ends of the sample with an electrically conductive Ag paste according to the usual method. The temperature was measured by means of a calibrated Au(Fe) - Ag thermocouple. The change in resistance was observed with rising the temperature little by little.

[Effects of the Invention]

As above described in detail, according to a method of producing a superconducting wire of the present invention, a long composite oxide superconducting material having a high critical temperature can be continuously produced. Thus, the superconducting material can be actually utilized as for example a transmission medium of electric power and the like. In addition, a long superconducting product produced according to the present invention has a metallic sheath member therearound, so that this metallic sheath member functions as a mechanical support member and a by-path of electric current when quenched.

Accordingly, the present invention exhibits an effect in that the composite wire comprising the conductor and the superconductor can be produced by a single continuous process.

**Claims**

1. A method of producing a superconducting wire comprising an oxide superconducting material having a high superconducting critical temperature, characterized by comprising a first step of continuously turning a long plate metal or alloy material into a pipe having an U-shaped section;
a second step of continuously supplying the inside of the resulting pipe having the U-shaped section with raw material powders, which raw material powders are any one of mixture powders formed of oxides, nitrides, fluorides, carbonates, nitrates, oxalates or sulfates of one kind of element $\alpha$ selected from elements of the group IIa in the periodic table, one kind of element $\beta$ selected from elements of the group IIIa in the periodic table and one kind of element $\gamma$ selected from elements of the groups Ib, IIb, IIIb, IVa and VIIIa in the periodic table and powders of baked composite oxides obtained by baking said mixture powders and pulverizing them;
a third step of turning said pipe having the U-shaped section into a pipe having an O-shaped section and subjecting butt portions of said plate material to the seam welding;
a fourth step of drawing the resulting pipe with the raw material powders housed therein; and
a fifth step of heating collectively to sinter said raw material powders.

2. A method of producing a superconducting wire as set forth in claim 1, characterized in that said baked composite oxides are expressed by the general formula $\alpha_w\beta_x\gamma_y\delta_z$ wherein the element $\alpha$ is one kind selected from elements of the group IIa in the periodic table; the element $\beta$ being one kind selected from elements of the group IIIa in the periodic table; the element $\gamma$ being one kind selected from elements of the groups Ib, IIb, IIIb and VIIIa in the periodic table; $\delta$ being 0; w, x, y and z being a number meeting $1 \leqq w \leqq 5$, $1 \leqq x \leqq 5$, $1 \leqq y \leqq 15$ and $1 \leqq z \leqq 20$, respectively.

3. A method of producing a superconducting wire as set forth in claim 1 and/or claim 2, characterized in that said plate material is turned into a pipe having a C-shaped section before it is turned into a pipe having a U-shaped section.

4. A method of producing a superconducting wire as set forth in any one of claim 1 to 3, characterized in that at least an inner surface of said plate material is subjected to a surface treatment prior to said second step.

5. A method of producing a superconducting wire as set forth in claim 4, characterized in that said surface treatment is a treatment of forming an oxidized film on a surface of said plate material.

6. A method of producing a superconducting wire as set forth in any one of claims 1 to 5, characterized in that said plate material is turned into the pipe having a U-shaped section by means of a forming roll.

7. A method of producing a superconducting wire as set forth in any one of claims 1 to 6, characterized in that said butt surfaces of the plate material are subjected to grinding to expose an activated surface prior to said third step.

8. A method of producing a superconducting wire as set forth in any one of claims 1 to 7, characterized in that said seam welding is carried out by the tungsten inert gas (TIG) welding in said third step.

9. A method of producing a superconducting wire as set forth in claim 8, characterized in that said tungsten inert gas (TIG) welding is carried out in an atmosphere of $N_2$ gas.

**10.** A method of producing a superconducting wire as set forth in any one of claims 1 to 9, characterized in that said fourth step is carried out by means of a reducing die.

**11.** A method of producing a superconducting wire as set forth in any one of claims 1 to 10, characterized in that the drawing process is carried out plural times repeatedly at a reduction in area of 30 % or less in said fourth step.

**12.** A method of producing a superconducting wire as set forth in any one of claims 1 to 11, characterized in that said plate material is formed of one kind of metal selected from the group consisting of stainless steel, Cu, Ag, Au, Pt, Pd, Rh, Fe, Pb, Sn, Cd, Ti, W, Mo, Zr, Hf, Ta and Nb or alloys thereof.

**13.** A method of producing a superconducting wire as set forth in any one of claims 1 to 12; characterized in that powders of oxides, carbonates, sulfates or nitrates of at least one kind of metal selected from the group consisting of V, Nb, Ta, Mo, W, Ti, Cr, Mn, Ga, In, Cd, Sn, Tl, Pb and Zn are additionally added to said raw material powders as additives.

**14.** A method of producing a superconducting wire as set forth in claim 13, characterized in that said additives are added at an atomic ratio of 0.01 to 0.15 based on one mol of said element.

**15.** A method of producing a superconducting wire as set forth in any one of claims 1 to 14, characterized in that said raw material powders have particle diameters of 30 microns or less.

**16.** A method of producing a superconducting wire as set forth in any one of claims 1 to 15, characterized in that the sintering is carried out with the melting point of the material having the lowest melting point of said raw material powders as an upper temperature limit so that the difference between the sintering temperature of said raw material powders and the melting point of said raw material powders is 100° C or less in said fifth step.

**17.** A method of producing a superconducting wire as set forth in any one of claims 1 to 16, characterized in that the sintered raw material powders are gradually cooled at a rate of 15°C/min or less in said fifth step.

**18.** A method of producing a superconducting wire as set forth in any one of claims 1 to 17, characterized in that said element $\alpha$ is Ba, said element $\beta$ being Y, and said element $\gamma$ being Cu.

**19.** A method of producing a superconducting wire as set forth in any one of claims 1 to 17, characterized in that said element $\alpha$ is Ba, said element $\beta$ being Ho, and said element $\gamma$ being Cu.

**20.** A method of producing a superconducting wire as set forth in any one of claims 1 to 17, characterized in that said element $\alpha$ is Ba, said element $\beta$ being Dy, and said element $\gamma$ being Cu.

**Patentansprüche**

**1.** Verfahren zur Herstellung eines supraleitenden Drahtes, der ein supraleitendes Oxidmaterial mit einer hohen Sprungtemperatur umfaßt, dadurch gekennzeichnet, daß sie die folgenden Stufen umfaßt:
eine erste Stufe der kontinuierlichen Umwandlung eines langen Blechs aus Metall oder Legierung in ein Rohr mit U-förmigem Querschnitt;
eine zweite Stufe des kontinuierlichen Einfüllens von Rohmaterial-Pulvern in die Innenseite des erhaltenen Rohrs mit U-förmigem Querschnitt, wobei die Rohmaterial-Pulver eine beliebige Pulvermischung aus Oxiden, Nitriden, Fluoriden, Carbonaten, Nitraten, Oxalaten oder Sulfaten einer Art von Element $\alpha$, ausgewählt aus den Elementen der Gruppe IIa im periodischen System, einer Art von Element $\beta$, ausgewählt von Elementen der Gruppe IIIa des periodischen Systems, und einer Art von Element $\gamma$, ausgewählt aus Elementen der Gruppe Ib, IIb, IIIb, IVa und VIIIa des periodischen Systems, und Pulver von gebrannten zusammengesetzten Oxiden sind, die erhalten wurden durch Brennen der Pulvermischungen und ihre Feinmahlung;
eine dritte Stufe der Umwandlung des Rohrs mit U-förmigem Querschnitt in ein Rohr mit O-förmigem Querschnitt und Unterwerfung von Stoßbereichen des Blechmaterials der Nahtschweißung;
eine vierte Stufe des Ziehens des erhaltenen Rohrs mit den darin untergebrachten Rohmaterial-Pulvern;

und

eine fünfte Stufe der gemeinsamen Erhitzung zum Sintern der Rohmaterial-Pulver.

2. Ein Verfahren zur Herstellung eines supraleitenden Drahtes nach Anspruch 1, dadurch gekennzeichnet, daß die gebrannten zusammengesetzten Oxide mit der allgemeinen Formel $\alpha_w\beta_x\gamma_y\delta_z$ bezeichnet werden, wobei das Element $\alpha$ ein Element aus den Elementen der Gruppe IIa im Periodensystem, das Element $\beta$ ein Element aus den Elementen der Gruppe IIIa im Periodensystem, das Element ein Element der Elemente der Gruppe Ib, IIb, IIIb und VIIIa im Periodensystem, $\delta$ = 0, w, x, y und z eine Zahl entsprechend $1 \leq w \leq 5$, $1 \leq x \leq 5$, $1 \leq y \leq 15$ und bzw. $1 \leq z \leq 20$ sind.

3. Verfahren zur Herstellung eines supraleitenden Drahtes nach Anspruch 1 und/oder 2, dadurch gekennzeichnet, daß das Blech in ein Rohr mit C-förmigem Querschnitt umgewandelt wird, bevor es in ein Rohr mit U-förmigem Querschnitt umgewandelt wird.

4. Verfahren zur Herstellung eines supraleitenden Drahtes nach einem der Ansprüche 1 - 3, dadurch gekennzeichnet, daß wenigstens eine innere Oberfläche des Blechs einer Oberflächenbehandlung vor der zweiten Stufe unterworfen wird.

5. Verfahren zur Herstellung eines supraleitenden Drahtes nach Anspruch 4, dadurch gekennzeichnet, daß die Oberflächenbehandlung eine Behandlung der Bildung eines oxidierten Films auf einer Oberfläche des Blechmaterials ist.

6. Verfahren zur Herstellung eines supraleitenden Drahtes nach einem der Ansprüche 1 - 5, dadurch gekennzeichnet, daß das Blechmaterial in das Rohr mit U-förmigem Querschnitt mittels einer Patrizenwalze umgewandelt wird.

7. Verfahren zur Herstellung eines supraleitenden Drahtes nach einem der Ansprüche 1 - 6, dadurch gekennzeichnet, daß die Stoßflächen des Blechs geschliffen werden, um eine aktivierte Oberfläche vor der dritten Stufe freizulegen.

8. Verfahren zur Herstellung eines supraleitenden Drahtes nach einem der Ansprüche 1 - 7, dadurch gekennzeichnet, daß das Nahtschweißen durch das Wolfram-Inertgas (TIG)-Schweißen in der dritten Stufe ausgeführt wird.

9. Verfahren zur Herstellung eines supraleitenden Drahtes nach Anspruch 8, dadurch gekennzeichnet, daß das Wolfram-Inertgas (TIG)-Schweißen in einer Atmosphäre von $N_2$-Gas durchgeführt wird.

10. Verfahren zur Herstellung eines supraleitenden Drahtes nach einem der Ansprüche 1 - 9, dadurch gekennzeichnet, daß die vierte Stufe mittels eines Reduziergesenks durchgeführt wird.

11. Verfahren zur Herstellung eines supraleitenden Drahtes nach einem der Ansprüche 1 - 10, dadurch gekennzeichnet, daß das Ziehverfahren mehrere Male wiederholt bei einer Flächenreduktion von 30 % oder weniger in der vierten Stufe durchgeführt wird.

12. Verfahren zur Herstellung eines supraleitenden Drahtes nach einem der Ansprüche 1 - 11, dadurch gekennzeichnet, daß das Blechmaterial aus einem Metall aus der Gruppe: Edelstahl, Cu, Ag, Au, Pt, Pd, Rh, Fe, Pb, Sn, Cd, Ti, W, Mo, Zr, Hf, Ta und Nb oder Legierungen hieraus ausgewählt ist.

13. Verfahren zur Herstellung eines supraleitenden Drahtes nach einem der Ansprüche 1 - 5, dadurch gekennzeichnet, daß die Pulver von Oxiden, Carbonaten, Sulfaten oder Nitraten von mindestens einer Metallart aus der Gruppe V, Nb, Ta, Mo, W, Ti, Cr, Mn, Ga, In, Cd, Sn, Tl, Pb und Zn zusätzlich zu den Materialpulvern als Zusätze zugegeben werden.

14. Verfahren zur Herstellung eines supraleitenden Drahtes nach Anspruch 13, dadurch gekennzeichnet, daß die Zusätze in einem Atomverhältnis von 0,01 bis 0,015, bezogen auf 1 mol des Elements, zugesetzt werden.

**15.** Verfahren zur Herstellung eines supraleitenden Drahtes nach einem der Ansprüche 1 - 14, dadurch gekennzeichnet, daß die Rohmaterialpulver Teilchengrößen von 30 μm oder weniger besitzen.

**16.** Verfahren zur Herstellung eines supraleitenden Drahtes nach einem der Ansprüche 1 - 15, dadurch gekennzeichnet, daß das Sintern so durchgeführt wird, daß der Schmelzpunkt des Materials, das den niedrigsten Schmelzpunkt von den Rohmaterialpulvern besitzt, als eine obere Temperaturgrenze genommen wird, so daß die Differenz zwischen der Sintertemperatur der Rohmaterialpulver und dem Schmelzpunkt der Rohmaterialpulver 100° C oder weniger in der fünften Stufe beträgt.

**17.** Verfahren zur Herstellung eines supraleitenden Drahtes nach einem der Ansprüche 1 - 16, dadurch gekennzeichnet, daß die gesinterten Rohmaterialpulver schrittweise mit einer Rate von 15° C/min oder weniger in der fünften Stufe abgekühlt werden.

**18.** Verfahren zur Herstellung eines supraleitenden Drahtes nach einem der Ansprüche 1 - 17, dadurch gekennzeichnet, daß das Element α Ba, das Element β Y und das Element γ Cu ist.

**19.** Verfahren zur Herstellung eines supraleitenden Drahtes nach einem der Ansprüche 1 - 17, dadurch gekennzeichnet, daß das Element α Ba, das Element β Ho und das Element γ Cu ist.

**20.** Verfahren zur Herstellung eines supraleitenden Drahtes nach einem der Ansprüche 1 - 17, dadurch gekennzeichnet, daß das Element α Ba, das Element β Dy und das Element γ Cu ist.

**Revendications**

**1.** Méthode de fabrication d'un fil supraconducteur comprenant une matière d'oxyde supraconductrice ayant une température critique supraconductrice élevée, caractérisée en ce qu'elle comprend une première étape consistant à transformer de manière continue une longue plaque en métal ou en alliage en un tuyau ayant une section en U ;
une seconde étape consistant à remplir de manière continue l'intérieur du tuyau obtenu ayant une section en U avec des poudres de matières premières, ces poudres de matières premières étant constituées de l'une des poudres mélangées formées à partir d'oxydes, de nitrures, de fluorures, de carbonates, de nitrates, d'oxalates ou de sulfates d'un type d'élément α sélectionné parmi les éléments du groupe IIa dans le tableau périodique des éléments, d'un type d'élément β sélectionné parmi les éléments du groupe IIIa dans le tableau périodique des éléments et d'un type d'élément γ sélectionné parmi les éléments des groupes Ib, IIb, IIIb, IVa et VIIIa dans le tableau périodique des éléments et de poudres d'oxydes composites cuites obtenues en faisant cuire lesdites poudres mélangées et en les pulvérisant ;
une troisième étape consistant à transformer ledit tuyau ayant une section en U en un tuyau ayant une Section en O et en soumettant des portions d'aboutementde ladite matière de plaque au soudage à la molette ;
une quatrième étape consistant à étirer le tuyau obtenu contenant les poudres de matières premières ; et
une cinquième étape consistant à chauffer collectivement de manière à fritter lesdites poudres de matières premières.

**2.** Méthode de fabrication d'un fil supraconducteur selon la revendication 1, caractérisée en ce que lesdits oxydes composites cuits sont désignés par la formule générale $\alpha_w \beta_x \gamma_y \delta_z$ dans laquelle l'élément α constitue un type sélectionné parmi les éléments du groupe IIa du tableau périodique des éléments ; l'élément β constitue un type sélectionné parmi les éléments du groupe IIIa du tableau périodique des éléments ; l'élément γ constitue un type sélectionné parmi les éléments du groupeIb, IIb, IIIb et VIIIa dans le tableau périodique des éléments ; δ correspondant à O ; w, x, y et z étant un nombre vérifiant $1 \leqq w \leqq 5$, $1 \leqq x \leqq 5$, $1 \leqq y \leqq 15$ et $1 \leqq z \leqq 20$, respectivement.

**3.** Méthode de fabrication d'un fil supraconducteur selon la revendication 1 et / ou 2, caractérisée en ce que la matière en plaque est transformée en tuyau ayant une section en C, avant d'être transformée en tuyau ayant une section en U.

**4.** Méthode de fabrication d'un fil supraconducteur selon l'une des revendications 1 à 3, caractérisée en ce qu'au moins une surface interne de ladite matière de plaque est soumise à un traitement de surface avant ladite seconde étape.

**5.** Méthode de fabrication d'un fil supraconducteur selon la revendication 4, caractérisée en ce que ledit traitement de surface est un traitement consistant à former un film oxydé sur une surface de ladite matière de plaque.

**6.** Méthode de fabrication d'un fil supraconducteur selon l'une des revendications 1 à 5, caractérisée en ce que ladite matière de plaque est transformée en tuyau ayant une section en U au moyen d'un rouleau de forme.

**7.** Méthode de fabrication un fil supraconducteur selon l'une des revendications 1 à 6, caractérisée en ce que lesdites surfaces d'aboutement de la matière de plaque sont soumises au ponçage de manière à exposer une surface activée avant ladite troisième étape.

**8.** Méthode de fabrication d'un fil supraconducteur selon l'une des revendications 1 à 7, caractérisée en ce que ledit soudage à la molette est effectué selon la méthode de soudage TIG dans ladite troisième étape.

**9.** Méthode de fabrication un fil supraconducteur selon la revendication 8, caractérisée en ce que ledit soudage TIG est effectué dans une atmosphère de gaz $N_2$.

**10.** Méthode de fabrication d'un fil supraconducteur selon l'une des revendications 1 à 9, caractérisée en ce que ladite quatrième étape est effectuée au moyen d'une matrice réductrice.

**11.** Méthode de fabrication d'un fil supraconducteur selon l'une des revendications 1 à 10, caractérisée en ce que le processus de laminage est effectué plusieurs fois successivement jusqu'à réduction de la section de 30% ou moins dans ladite quatrième étape.

**12.** Méthode de fabrication d'un fil supraconducteur selon l'une des revendications 1 à 11, caractérisée en ce que ladite matière de plaque est formée d'un type de métal sélectionné dans le groupe consistant en acier inoxydable, Cu, Ag, Au, Pt, Pd, Rh, Fe, Pb, Sn, Cd, Ti, W, Mo, Zr, Hf, Ta et Nb et des alliages de ceux-ci.

**13.** Méthode de fabrication d'un fil supraconducteur selon l'une des revendications 1 à 12, caractérisée en ce que des poudres d'oxydes, de carbonates, de sulfates ou de nitrates d'au moins un type de métal sélectionné dans le groupe consistant en V, Nb, Ta, Mo, W, Ti, Cr, Mn, Ga, In, Cd, Sn, Tl, Pb et Zn sont additionnellement ajoutées auxdites poudres de matières premières comme additifs.

**14.** Méthode de fabrication d'un fil supraconducteur selon la revendication 13, caractérisée en ce que lesdits additifs sont ajoutés selon un rapport atomique de 0,01 à 0,15 sur la base d'une mole dudit élément.

**15.** Méthode de fabrication d'un fil supraconducteur selon l'une des revendications 1 à 14, caractérisée en ce que lesdites poudres de matières premières ont un diamètre de particules de 30 microns ou moins.

**16.** Méthode de fabrication d'un fil supraconducteur selon l'une des revendications 1 à 15, caractérisée en ce que le frittage est effectué avec le point de fusion de la matière ayant le point de fusion le plus bas desdites poudres de matières premières comme limite de température supérieure, de sorte que la différence entre la température de frittage desdites poudres de matières premières et le point de fusion desdites poudres de matières premières est de 100°C ou moins dans ladite cinquième étape.

**17.** Méthode de fabrication d'un fil supraconducteur selon l'une des revendications 1 à 16, caractérisée en ce que les poudres de matières premières frittées sont graduellement refroidies à une allure de 15°C/min ou moins dans ladite cinquième étape.

18. Méthode de fabrication d'un fil supraconducteur selon l'une des revendications 1 à 17, caractérisée en ce que ledit élément $\alpha$ est Ba, ledit élément $\beta$ étant Y et ledit élément $\gamma$ étant Cu.

19. Méthode de fabrication d'un fil supraconducteur selon l'une des revendications 1 à 17, caractérisée en ce que ledit élément $\alpha$ est Ba, ledit élément $\beta$ étant Ho et ledit élément $\gamma$ étant Cu.

20. Méthode de fabrication d'un fil supraconducteur selon l'une des revendications 1 à 17, caractérisée en ce que ledit élément $\alpha$ est Ba, ledit élément $\beta$ étant Dy et ledit élément $\gamma$ étant Cu.

# F I G. 1

## (a)

## (b)

## (c)

## (d)

## (e)